# FASCICULE DE BREVET EUROPEEN

(11) **EP 3 836 765 B1**
(45) Date de publication et mention de la délivrance du brevet: **11.09.2024**
(21) Numéro de dépôt: 20210388.3
(22) Date de dépôt: 27.11.2020
(51) Int. Cl.: H05K 7/14, H05K 7/12

(54) **MODULE D'ISOLATION ÉLECTRIQUE POUR ÉQUIPEMENT ÉLECTRIQUE HAUTE TENSION**
ELEKTRISCHES ISOLATIONSMODUL FÜR ELEKTRISCHE HOCHSPANNUNGSAUSSTATTUNG
ELECTRICAL INSULATION MODULE FOR HIGH-VOLTAGE ELECTRICAL EQUIPMENT

(30) Priorité: 12.12.2019 FR 1914292
(43) Date de publication de la demande: 16.06.2021
(73) Titulaire: Valeo Electrification, 95800 Cergy (FR)
(72) Inventeur: TRAMET, Guillaume, 78920 ECQUEVILLY (FR); SMAL, Pierre, 78500 SARTROUVILLE (FR); TSOURIA-BELAID, Mahi-Eddine, 75012 PARIS (FR)
(74) Mandataire: Valeo Powertrain Systems

(56) Documents cités:
- EP-A1- 2 015 322
- WO-A1-2015/059552
- DE-A1- 102016 222 823
- DE-B3- 102010 043 445
- US-A- 3 803 457

## Description

### DOMAINE TECHNIQUE ET OBJET DE L'INVENTION

La présente invention concerne, de façon générale, le domaine des équipements électriques.

L'invention porte plus particulièrement sur des équipements électriques haute tension pour véhicules électriques ou hybrides.

### ETAT DE LA TECHNIQUE

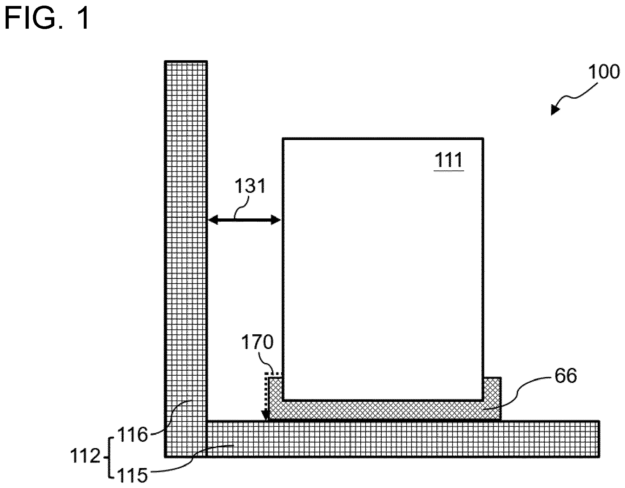

Un équipement électrique d'un véhicule électrique ou hybride, tel qu'un onduleur d'un véhicule électrique, comprend des composants électriques logés dans un boîtier de l'équipement électrique, comme illustré en figure 1. La figure 1 illustre la coupe longitudinale d'un équipement électrique 100 comprenant un boîtier 112 et un composant électrique 111. Le boîtier 112, comprenant une paroi latérale 116 et une plaque de base 115, est en général en métal. Le composant électrique 111 est par exemple, comme le boîtier 112, un objet conducteur électrique. Alternativement, le composant électrique 111 peut comprendre une enveloppe externe isolante qui est susceptible de présenter un défaut. Un tel défaut entraine éventuellement un courant de fuite entre le composant électrique 111 et le boîtier 112.

Pour améliorer la dissipation thermique et isoler le composant électrique 111 avec la plaque de base 115, l'équipement électrique comprend généralement un coussin thermique 66. Le coussin thermique 66 est placé entre la plaque de base 115 du boîtier 112 et le composant électrique 111. Le coussin thermique 66 est d'un matériau isolant et présente une conductivité thermique permettant une dissipation de la chaleur entre le composant électrique 111 et la plaque de base 115.

La différence de potentiel électrique entre le boîtier 112 et le composant électrique 111, notamment entre la paroi latérale 116 et le composant électrique 111, détermine une distance de sécurité électrique 131, qu'il faut respecter afin d'éviter la création d'un cheminement électrique parasitaire entre le composant électrique 111 et le boîtier 112 à travers l'air. Par exemple, dans l'équipement électrique 100, la distance minimale entre le composant électrique 111 et la paroi latérale 116 doit être d'une distance supérieure à cette distance de sécurité électrique 131, de façon à assurer que, durant l'utilisation de l'équipement électrique 100, il n'y ait pas de possibilité de rupture de l'isolation électrique à travers l'air.

En outre la différence de potentiel électrique entre le boîtier 112 et le composant électrique 111, notamment entre la paroi de base 115 et le composant électrique 111, détermine une ligne de fuite 170. On détermine la ligne de fuite 170 comme le chemin de résistance le plus faible suivi par un courant électrique de surface parasitaire entre le composant électrique 111 et le boîtier 112, notamment entre le composant électrique 111 et la plaque de base 115. Dans le cas présent la ligne de fuite 170 s'étend notamment le long de la surface externe du coussin thermique 66 entre le composant électrique 111 et la plaque de base 115. La ligne de fuite 170 suit le contour du coussin thermique 66 avant de toucher la plaque de base 115. La ligne de fuite 170 doit être suffisamment longue pour qu'un courant électrique parasitaire entre le composant électrique 111 et le boîtier 112 n'apparaisse pas.

Cependant, si le composant électrique 111 de l'équipement électrique 100 de la figure 1 est un composant électrique haute tension (désigné « High Voltage », « HV » en anglais), ladite différence de potentiel électrique est trop importante pour que la ligne de fuite 170 soit suffisamment longue pour éviter l'apparition d'un courant de fuite en surface. Dans ce cas, pour l'équipement électrique 100, il est très important de rallonger encore la ligne de fuite 170, tout en limitant l'encombrement dans l'équipement électrique 100.

WO2015/059552A1 décrit un convertisseur de puissance comprenant un boîtier, des composants électriques (i.e. « capacités ») et un module d'isolation électrique qui comprend une entretoise configurée pour loger et positionner les composants électriques.

DE102016222823A1 concerne un dispositif de commande comprenant des composants électriques, et un module d'isolation électrique qui comprend un élément d'isolation. L'élément d'isolation est disposé entre les composants électriques logés dans la zone de haute tension et dans la zone de basse tension, afin de séparer les composants électriques dans la zone de haute tension de ceux dans la zone de basse tension.

Pour pallier au moins un des inconvénients précités, la présente invention vise une solution non coûteuse qui permet d'augmenter la longueur de la ligne de fuite sans augmentation de la taille d'un équipement électrique.

### PRESENTATION GENERALE DE L'INVENTION

Pour parvenir à ce résultat, la présente invention concerne un module d'isolation électrique tel que défini par la revendication indépendante.

L'invention permet donc d'augmenter la longueur de la ligne de fuite sans augmentation de la taille d'un équipement électrique.

Avantageusement, ledit angle interne est compris entre 80 et 110 degrés.

De façon avantageuse, ladite entretoise comprend une cavité de réception définie par la paroi de fond et la paroi périphérique est configurée pour recevoir au moins une portion de l'au moins un composant électrique. Notamment, la paroi de fond est configurée pour recevoir ledit composant électrique contre elle, et la paroi périphérique est configurée pour venir au moins en partie autour dudit composant électrique.

De manière préférentielle, la paroi périphérique comprend un rebord, l'au moins une ligne de fuite comprenant en outre une dimension d'une surface dudit rebord. En particulier, la paroi périphérique est en contact avec la paroi de fond au niveau d'une première extrémité de la paroi périphérique et la paroi périphérique comprend une deuxième extrémité opposée à la première extrémité ; ledit rebord s'étendant depuis la deuxième extrémité suivant une direction transversale par rapport à la paroi périphérique.

Le module d'isolation électrique comporte un coussin thermique configuré pour être positionné entre ledit composant électrique et ladite entretoise, ledit coussin thermique étant configuré pour évacuer au moins une partie de la chaleur générée lors du fonctionnement du composant électrique.

Avantageusement, l'entretoise comprend une ouverture formée dans la paroi de fond et configurée pour permettre un contact entre le coussin thermique et une paroi du boîtier de manière à évacuer au moins une partie de ladite chaleur générée.

De façon avantageuse, le coussin thermique est fait d'un matériau déformable. Notamment, le coussin thermique est configuré pour se déformer lorsque le composant électrique est reçu dans la cavité de réception, en particulier contre la paroi de fond. Le coussin thermique étant interposé entre ledit composant électrique et ladite paroi de fond. Le coussin thermique se déforme notamment de sorte à traverser l'ouverture de la paroi de fond pour venir en contact avec la paroi du boîtier.

La présente invention concerne également un équipement électrique comprenant un boîtier et au moins un composant électrique ; ledit boîtier comprenant au moins un logement défini par une paroi latérale et une plaque de support sur laquelle l'au moins un composant électrique est monté ; l'équipement électrique comprenant un module d'isolation électrique tel que brièvement décrit ci-dessus.

Selon une variante, le composant électrique est reçu dans ladite cavité de réception du module d'isolation électrique.

Selon une variante, une première ligne de fuite s'étend successivement le long d'une surface externe supérieure du coussin thermique située entre le composant électrique et la paroi périphérique ; et d'une surface interne de la paroi périphérique dépourvue du coussin thermique.

Selon une variante particulière, la paroi périphérique de l'entretoise est en contact avec la paroi latérale du boitier ; et la première ligne de fuite s'étend jusqu'à la paroi latérale du boitier.

Alternativement, la paroi périphérique de l'entretoise est à distance de la paroi latérale du boitier ; et la première ligne de fuite s'étend le long d'une surface externe de la paroi périphérique de l'entretoise jusqu'à ladite plaque de support.

Selon une variante, une première ligne de fuite s'étend successivement le long d'une surface externe supérieure du coussin thermique située entre le composant électrique et la paroi périphérique ; d'une surface interne de la paroi périphérique dépourvue du coussin thermique ; et une surface externe de la paroi périphérique jusqu'à ladite plaque de support.

Selon une variante, une deuxième ligne de fuite s'étend successivement le long d'une surface externe supérieure du coussin thermique située entre le composant électrique et la paroi périphérique ; une première surface de contact entre le coussin thermique et ladite paroi périphérique ; et une troisième surface de contact entre le coussin thermique et ladite paroi de fond jusqu'à ladite plaque de support.

De manière préférentielle, l'au moins un composant électrique est un élément capacitif ou une bobine ou une capacité ou un transformateur.

Préférentiellement, ledit équipement électrique est un onduleur ou un convertisseur tension continu-continu ou un chargeur électrique, notamment configurés pour être embarqués dans un véhicule.

Préférentiellement, l'au moins un composant électrique est un composant électrique haute tension.

Avantageusement, ladite plaque de support est une plaque de base dudit boîtier, ou une plaque intermédiaire installée entre une plaque de base et une ouverture dudit boîtier.

De façon avantageuse, ladite paroi latérale est orthogonale à ladite plaque de support, ladite paroi latérale étant une paroi périphérique dudit boîtier ou une paroi de cloisonnement installée dans ledit boîtier.

### PRESENTATION DES FIGURES

D'autres caractéristiques et avantages de l'invention apparaîtront encore à la lecture de la description qui va suivre. Celle-ci est purement illustrative et doit être lue en regard des dessins annexés sur lesquels :
Fig. 1 : la figure 1 illustre la coupe longitudinale d'un équipement électrique conventionnel comprenant un coussin thermique ;
Fig. 2 : la figure 2 illustre la coupe longitudinale d'un module d'isolation électrique installé dans un équipement électrique, selon un mode de réalisation de l'invention ;
Fig. 3 : la figure 3 illustre une entretoise du module d'isolation électrique selon un mode de réalisation de l'invention ; et
Fig. 4 : la figure 4 illustre l'entretoise selon une perspective différente de celle de la figure 3.

Il faut noter que les figures exposent l'invention de manière détaillée pour mettre en oeuvre l'invention, lesdites figures pouvant bien entendu servir à mieux définir l'invention le cas échéant.

### DESCRIPTION DETAILLEE D'UNE FORME DE REALISATION DE L'INVENTION

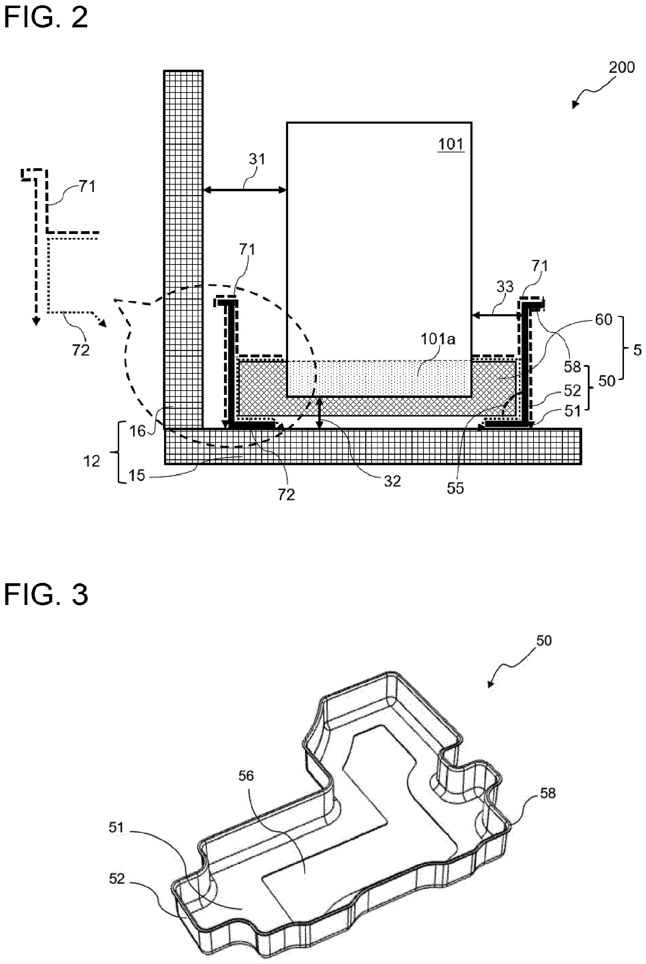

La figure 2 illustre la coupe longitudinale d'un module d'isolation électrique 5, installé dans un équipement électrique 200, selon un mode de réalisation de l'invention. L'équipement électrique 200 comprend un boîtier, au moins un composant électrique 101, et le module d'isolation électrique 5. Pour faciliter la compréhension, l'exemple de l'équipement électrique 200 illustré en figure 2 comprend un seul composant électrique 101.

Le module d'isolation électrique 5, étant en matériau isolant électrique, est configuré pour définir au moins une ligne de fuite 71, 72 de l'équipement électrique 200, la longueur de ladite au moins une ligne de fuite étant augmentée par rapport à l'art antérieur. Le module d'isolation électrique 5 sera décrit plus en détail dans les paragraphes suivants.

Le boîtier comprend au moins un logement configuré pour héberger l'au moins un composant électrique 101. La figure 2 décrit un tel logement 12. Le logement 12 est défini par une paroi latérale 16 et une plaque de support 15 sur laquelle l'au moins un composant électrique 101 est monté. De manière préférentielle, la paroi latérale 16 et la plaque de support 15 sont respectivement faites d'un matériau conducteur électrique, tel qu'un matériau métallique. Avantageusement, ledit matériau conducteur est un métal ou un alliage métallique, choisi par exemple dans les matériaux suivants : aluminium, cuivre, alliage d'aluminium, alliage de cuivre magnésium.

Dans un mode de réalisation, le boîtier de l'équipement électrique 200 comprend un seul logement. Dans ce cas, la plaque de support 15 est une plaque de base dudit boîtier. La paroi latérale 16 est une paroi latérale du boîtier. Dans un mode de réalisation alternatif, le boîtier comprend plusieurs logements. Au moins un de ces logements dont la paroi latérale 16 et/ou la plaque de support 15 sont respectivement une paroi de cloisonnement et/ou une plaque intermédiaire installées à l'intérieur du boîtier de l'équipement électrique 200. Ladite paroi de cloisonnement est de préférence parallèle à la paroi latérale du boîtier. Ladite plaque intermédiaire, installée entre une ouverture supérieure du boîtier et la plaque de base du boîtier, est de préférence parallèle à la plaque de base du boîtier.

Selon un exemple, les épaisseurs de la paroi latérale 16 et de la plaque de support 15 sont respectivement 4 mm (millimètre) et 4 mm. De plus, dans le présent mode de réalisation, le boîtier et le logement présentent respectivement une forme de parallélépipède rectangle. De manière alternative, le boîtier et le logement peuvent présenter une autre forme, par exemple un cylindre.

La paroi latérale 16 est de préférence orthogonale à la plaque de support 15 ; c'est-à-dire un angle interne entre la plaque de support 15 et la paroi latérale 16 est égal à 90 degrés. De manière alternative, ledit angle interne peut être compris entre 80 et 110 degrés.

Dans un mode de réalisation, l'au moins un composant électrique 101 est configuré pour présenter un potentiel électrique. Le composant électrique 101 est par exemple un élément capacitif, une bobine, une capacité, ou un transformateur. Le composant électrique 101 peut être un composant électrique haute tension. La haute tension désigne de préférence une tension supérieure à 60V (Volts) voire supérieure à 80V, voire même supérieure à 100V. L'équipement électrique 200 peut être un onduleur, un convertisseur tension continu-continu (« DC-to-DC Voltage converter» en anglais) ou un chargeur électrique, notamment configurés pour être embarqués dans un véhicule. Dans un mode de réalisation, le composant électrique 101 comporte une enveloppe isolante. La partie du composant électrique 101 en vis-à-vis d'une paroi de fond 51 d'une entretoise 50 (décrite plus en détail ci-après) et en contact avec un coussin thermique 60 (décrit plus en détail ci-après) est dépourvue de l'enveloppe isolante afin de favoriser l'échange thermique. La partie du composant électrique 101 en vis-à-vis de la paroi de fond 51 comprend notamment une partie conductrice thermique, notamment métallique.

De manière préférentielle, il existe un premier espacement 31 entre la paroi latérale 16 du logement 12 et l'au moins un composant électrique 101. Le premier espacement 31 est avantageusement compris entre 0 mm et 10 mm. La longueur du premier espacement 31 est supérieure ou égale à une distance d'isolation électrique par l'air.

Préférentiellement, il existe un deuxième espacement 32 entre la plaque de support 15 du logement 12 et l'au moins un composant électrique 101. Le deuxième espacement 32 est avantageusement compris entre 0.5 mm et 5 mm. Dans un mode de réalisation où ledit coussin thermique 60 est utilisé, le deuxième espacement 32 est largement rempli par l'épaisseur du coussin thermique 60.

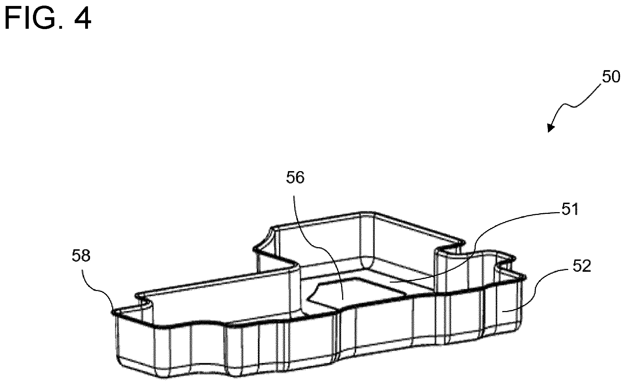

Le module d'isolation électrique 5 comprend ladite entretoise 50. Les figures 3 et 4 illustrent, selon deux perspectives différentes, l'entretoise 50 selon un mode de réalisation de l'invention. L'entretoise 50 comprend ladite paroi de fond 51, une paroi périphérique 52 et une cavité de réception. La paroi périphérique 52, se situant de préférence entre l'au moins un composant électrique 101 et la paroi latérale 16, suit une direction différente de celle du premier espacement 31. La paroi de fond 51 et/ou la paroi périphérique 52 peuvent être multi-épaisseurs, c'est-à-dire présenter des épaisseurs variables. Dans un mode de réalisation, un angle interne 55 formé entre la paroi de fond 51 et la paroi périphérique 52 est compris entre 80 et 110 degrés. La paroi périphérique 52 est de préférence orthogonale à la paroi de fond 51 ; c'est-à-dire ledit angle interne 55 étant 90 degrés.

La paroi périphérique 52 comprend de préférence un rebord 58, notamment configuré pour permettre de saisir et manipuler l'entretoise 50. Le rebord 58 est formé à une deuxième extrémité de la paroi périphérique 52 qui est distale par rapport à une première extrémité de la paroi périphérique 52 depuis laquelle la paroi de fond 51 s'étend. De manière préférentielle, l'entretoise 50 est formé d'un seul tenant. De plus, l'entretoise 50 peut être fabriquée par la réalisation d'un procédé de fabrication par emboutissage, et le rebord 58 peut donc être imposé par un processus d'emboutissage. Le rebord 58 est compté ainsi dans la première ligne de fuite 71, ce qui permet donc de réduire la hauteur de l'entretoise 50, notamment la distance entre la première extrémité de la paroi périphérique 52 et la deuxième extrémité de la paroi périphérique 52.

Ladite cavité de réception, définie par la paroi de fond 51 et la paroi périphérique 52, est configurée pour recevoir au moins une portion 101a de l'au moins un composant électrique 101, comme par exemple illustré en figure 2. L'entretoise 50 est placée dans le logement 12. Plus précisément, l'entretoise 50 est placée entre l'au moins un composant électrique 101 et l'ensemble de la plaque de support 15 et de la paroi latérale 16. De manière préférentielle, il existe un troisième espacement 33 entre la paroi périphérique 52 et la portion 101a de l'au moins un composant électrique 101. Le troisième espacement 33, étant notamment inférieur au premier espacement 31. Le troisième espacement 33 est avantageusement compris entre 0.5 mm et 10 mm.

Le matériau de l'entretoise 50 est de préférence en plastique/matière isolante. Les épaisseurs de la paroi de fond 51 et de la paroi périphérique 52 sont respectivement de préférence très fines, par exemple entre 0.25 mm et 1.2 mm. Ladite cavité de réception est de préférence une cavité avec un fond plat. La hauteur de le paroi périphérique 52, notamment la distance entre la première extrémité de la paroi périphérique 52 et la deuxième extrémité de la paroi périphérique 52, doit être au minimum 10 mm. La forme et le volume de la cavité de réception sont déterminées en fonctions de la forme et du volume de la portion 101a de l'au moins un composant électrique 101.

Dans un mode de réalisation illustré en figure 2, le module d'isolation électrique 5 comprend en outre le coussin thermique 60 placé entre l'au moins un composant électrique 101 et l'entretoise 50. L'entretoise 50 comprend en outre une ouverture 56 formée dans la paroi de fond 51 et configurée pour permettre un contact entre le coussin thermique 60 et une paroi du boîtier, notamment contre la plaque de support 15, de manière à évacuer au moins une partie de la chaleur générée. Le coussin thermique 60 est configuré pour absorber au moins une partie de la chaleur générée lors du fonctionnement de l'au moins un composant électrique 101, et pour évacuer à travers l'ouverture 56 au moins une partie de ladite chaleur générée.

Le coussin thermique 60 est de préférence fait d'un matériau déformable voire élastique. De manière avantageuse, le matériau du coussin thermique 60 est un matériau silicone ou céramique. L'épaisseur du coussin thermique 60 en état libre est comprise de préférence entre 0.5 mm et 10 mm. L'épaisseur du coussin thermique 60 en état compressé est comprise de préférence entre 0.25 mm et 5 mm. Dans son état compressé, le coussin thermique 60 remplit le deuxième espacement 32 (comme mentionnée précédemment) pour venir contre la plaque de support 15.

L'au moins une ligne de fuite, par exemple les lignes de fuite 71 et 72, est déterminée en fonction d'une surface correspondant à une portion de la paroi de fond 51, et/ou d'au moins une portion de la paroi périphérique 52. Ladite surface correspondant à une portion de la paroi de fond 51 peut être une surface de la paroi de fond 51 elle-même, ou une autre surface qui n'appartient pas à, mais est parallèle à la paroi de fond 51, par exemple une surface externe supérieure du coussin thermique 60 située entre le composant électrique 101 et la paroi périphérique 52.

Plus précisément, l'au moins une ligne de fuite est déterminée en fonction d'au moins une des surfaces suivantes définies par la présence du module d'isolation électrique 5, car un éventuel courant de fuite serait contraint de parcourir ces surfaces : une surface externe supérieure du coussin thermique 60 située entre le composant électrique 101 et la paroi périphérique 52 ; une première surface de contact entre le coussin thermique 60 et ladite paroi périphérique 52 ; une troisième surface de contact entre le coussin thermique 60 et ladite paroi de fond 51 ; une surface de la paroi périphérique 52 formant une surface interne (c'est-à-dire tournée vers la cavité de réception) de la paroi périphérique 52 dépourvue du coussin thermique 60, c'est-à-dire une surface interne de la paroi périphérique 52 située entre le coussin thermique 60 et la deuxième extrémité de la paroi périphérique 52 ; une surface externe (c'est-à-dire opposée à la cavité interne) de la paroi périphérique 52 qui s'étend notamment entre ladite deuxième extrémité et la plaque de support 15 ; le cas échant, une surface du rebord 58. Plus les surfaces disponibles sont utilisées, plus la longueur de la ligne de fuite augmente.

Comme illustré par exemple en figure 2, une première ligne de fuite 71 est déterminée en fonction de l'ensemble des surfaces suivantes : la surface externe supérieure du coussin thermique 60 située entre le composant électrique 101 et la paroi périphérique 52 ; la surface interne de la paroi périphérique 52 dépourvue du coussin thermique 60 ; et la surface externe de la paroi périphérique 52 qui s'étend notamment entre ladite deuxième extrémité et la plaque de support 15. La première ligne de fuite 71 comprend ainsi une dimension correspondant au parcours de la surface externe supérieure du coussin thermique 60, une dimension correspondant au parcours de la surface interne de la paroi périphérique 52 dépourvue du coussin thermique 60, et une dimension correspondant au parcours de la surface externe de la paroi périphérique 52 qui s'étend notamment entre ladite deuxième extrémité et la plaque de support 15. Si la paroi périphérique 52 comprend un rebord 58, la première ligne de fuite 71 est en outre déterminée en fonction de la surface dudit rebord 58. Dès lors, la première ligne de fuite 71 comprend aussi une dimension correspondant au parcours de la surface du rebord 58. Alternativement, la paroi périphérique 52 de l'entretoise 50 peut être en contact avec la paroi latérale 16 du boîtier. La première ligne de fuite 71 s'étend alors jusqu'à la paroi latérale 16 du boîtier, et s'arrête notamment au niveau de l'extrémité de la paroi périphérique 52 qui est en contact avec la paroi latérale 16 du boîtier.

Par ailleurs, une deuxième ligne de fuite 72 est déterminée en fonction de l'ensemble des surfaces suivantes : la surface externe supérieure du coussin thermique 60 située entre le composant électrique 101 et la paroi périphérique 52 ; ladite première surface de contact entre le coussin thermique 60 et ladite paroi périphérique 52 ; et ladite troisième surface de contact entre le coussin thermique 60 et ladite paroi de fond 51. La deuxième ligne de fuite 72 comprend ainsi une dimension correspondant au parcours de la surface externe supérieure du coussin thermique 60, une dimension correspondant au parcours de la deuxième surface de contact et une dimension correspondant au parcours de la troisième surface de contact.

Par rapport à la ligne de fuite illustrée dans l'art antérieur, l'invention permet de largement rallonger les lignes de fuite 71, 72 en utilisant lesdites surfaces définies par la présence du module d'isolation électrique 5. De plus, l'entretoise 50 est très léger et facile à monter à l'équipement électrique 200, ce qui ne complique donc pas la fabrication de l'équipement électrique 200.

L'invention propose donc une solution aisée à mettre en oeuvre et non coûteuse qui, d'une part, augmente la longueur de la ligne de fuite sans augmentation de la taille d'un équipement électrique et, d'autre part, améliore la dissipation de la chaleur générée lors du fonctionnement de l'équipement électrique.

L'invention n'est pas limitée aux modes de réalisation précédemment décrits mais s'étend à tout mode de réalisation conforme aux revendications.

Notamment, dans une variante, la paroi de fond 51 ne comprend pas d'ouverture. En particulier, la paroi de fond 51 forme alors une paroi pleine bordée par la paroi latérale 16. Le module d'isolation électrique 5 présente alors la première ligne de fuite 71.

En particulier, le composant électrique 101 peut alors venir directement sur la paroi de fond 51. Le module d'isolation électrique 5 est alors dépourvu du coussin thermique 60. La première ligne de fuite 71 peut alors comprendre une surface interne de la paroi de fond 51 située entre le composant électrique 101 et la paroi latérale 52, lorsque le composant électrique 101 est à distance de la paroi latérale 52. Le composant électrique 101 peut alternativement venir contre la paroi latérale 52 de sorte que la première ligne de fuite 71 comprend la surface interne de la paroi périphérique 52 et la surface externe de la paroi périphérique 52 qui s'étend notamment entre la deuxième extrémité de la paroi périphérique 52 et la plaque de support 15.

## Revendications

1. Module d'isolation électrique (5) configuré pour déterminer au moins une ligne de fuite (71, 72) entre un composant électrique (101) et un boîtier recevant ledit composant électrique (101) ; le module d'isolation électrique (5) est en matériau isolant électrique et comprend :
- une entretoise (50), comprenant une paroi de fond (51) et une paroi périphérique (52), ladite entretoise (50) étant configurée pour définir l'au moins une ligne de fuite (71, 72) entre ledit composant électrique (101) et ledit boîtier ;
dans laquelle :
• la paroi périphérique (52) suit une direction différente de celle de la paroi de fond (51), un angle interne (55) étant formé entre la paroi de fond (51) et la paroi périphérique (52) ; et
• l'au moins une ligne de fuite (71, 72) comprend au moins une dimension d'une surface correspondant à une portion de la paroi de fond (51) et/ou une dimension d'une surface d'une portion de la paroi périphérique (52) ;
- un coussin thermique (60) configuré pour être positionné entre ledit composant électrique (101) et ladite entretoise (50), ledit coussin thermique (60) étant configuré pour évacuer, au moins une partie de la chaleur générée lors du fonctionnement du composant électrique (101).

2. Module d'isolation électrique (5) selon la revendication 1, dans lequel ledit angle interne (55) est compris entre 80 et 110 degrés.

3. Module d'isolation électrique (5) selon une quelconque des revendications 1 et 2, dans lequel ladite entretoise (50) comprend une cavité de réception définie par la paroi de fond (51) et la paroi périphérique (52) et configurée pour recevoir au moins une portion (101a) de l'au moins un composant électrique (101).

4. Module d'isolation électrique (5) selon une quelconque des revendications 1 à 3, dans lequel la paroi périphérique (52) comprend un rebord (58), l'au moins une ligne de fuite (71, 72) comprenant en outre une dimension d'une surface dudit rebord (58).

5. Module d'isolation électrique (5) selon une quelconque des revendications 1 à 4, dans lequel l'entretoise (50) comprend une ouverture (56) formée dans la paroi de fond (51) et configurée pour permettre un contact entre le coussin thermique (60) et une paroi du boîtier de manière à évacuer au moins une partie de ladite chaleur générée.

6. Module d'isolation électrique (5) selon une quelconque des revendications 1 à 5, dans lequel le coussin thermique (60) est fait d'un matériau déformable.

7. Equipement électrique (200) comprenant un boîtier et au moins un composant électrique (101) ; ledit boîtier comprenant au moins un logement (12) défini par une paroi latérale (16) et une plaque de support (15) sur laquelle l'au moins un composant électrique (101) est monté ; l'équipement électrique (200) étant **caractérisé en ce qu'**il comprend :
- un module d'isolation électrique (5) selon l'une quelconque des revendications 1 à 6.

8. Equipement électrique (200) selon la revendication 7, dans lequel une première ligne de fuite (71) s'étend successivement le long d'une surface externe supérieure du coussin thermique (60) située entre le composant électrique (101) et la paroi périphérique (52) ; et d'une surface interne de la paroi périphérique (52) dépourvue du coussin thermique (60).

9. Equipement électrique (200) selon la revendication 7 ou 8, comprenant un module d'isolation électrique (5) selon la revendication 5, ledit équipement électrique (200) dans lequel une deuxième ligne de fuite (72) s'étend successivement le long d'une surface externe supérieure du coussin thermique (60) située entre le composant électrique (101) et la paroi périphérique (52) ; une première surface de contact entre le coussin thermique (60) et ladite paroi périphérique (52) ; et une troisième surface de contact entre le coussin thermique (60) et ladite paroi de fond (51) jusqu'à ladite plaque de support (15).

## Patentansprüche

1. Elektrisches Isolationsmodul (5), das dazu konfiguriert ist, mindestens eine Kriechstrecke (71, 72) zwischen einem elektrischen Bauteil (101) und einem Gehäuse, das das elektrische Bauteil (101) aufnimmt, zu bestimmen; das elektrische Isolationsmodul (5) ist aus einem elektrisch isolierenden Material und dass es Folgendes beinhaltet:
- einen Abstandshalter (50), der eine Bodenwand (51) und eine Umfangswand (52) beinhaltet, wobei der Abstandshalter (50) dazu konfiguriert ist, die mindestens eine Kriechstrecke (71, 72) zwischen dem elektrischen Bauteil (101) und dem Gehäuse zu definieren;
wobei:
• die Umfangswand (52) einer anderen Richtung folgt als die Bodenwand (51), wobei zwischen der Bodenwand (51) und der Umfangswand (52) ein Innenwinkel (55) gebildet ist; und
• die mindestens eine Kriechstrecke (71, 72) mindestens eine Abmessung einer Oberfläche, die einem Abschnitt der Bodenwand (51) entspricht, und/oder eine Abmessung einer Oberfläche eines Abschnitts der Umfangswand (52) beinhaltet;
- ein Wärmeleitpad (60), das dazu konfiguriert ist, zwischen dem elektrischen Bauteil (101) und dem Abstandshalter (50) positioniert zu sein, wobei das Wärmeleitpad (60) dazu konfiguriert ist, mindestens einen Teil der während des Betriebs des elektrischen Bauteils (101) erzeugten Wärme abzuführen.

2. Elektrisches Isolationsmodul (5) nach Anspruch 1, wobei der Innenwinkel (55) zwischen 80 und 110 Grad beträgt.

3. Elektrisches Isolationsmodul (5) nach einem beliebigen der Ansprüche 1 und 2, wobei der Abstandshalter (50) einen Aufnahmeraum beinhaltet, der durch die Bodenwand (51) und die Umfangswand (52) definiert wird und dazu konfiguriert ist, mindestens einen Abschnitt (101a) des mindestens einen elektrischen Bauteils (101) aufzunehmen.

4. Elektrisches Isolationsmodul (5) nach einem beliebigen der Ansprüche 1 bis 3, wobei die Umfangswand (52) einen Rand (58) beinhaltet, wobei die mindestens eine Kriechstrecke (71, 72) ferner eine Abmessung einer Oberfläche des Rands (58) beinhaltet.

5. Elektrisches Isolationsmodul (5) nach einem beliebigen der Ansprüche 1 bis 4, wobei der Abstandshalter (50) eine Öffnung (56) beinhaltet, die in der Bodenwand (51) gebildet ist und dazu konfiguriert ist, einen Kontakt zwischen dem Wärmeleitpad (60) und einer Wand des Gehäuses zu gestatten, um mindestens einen Teil der erzeugten Wärme abzuführen.

6. Elektrisches Isolationsmodul (5) nach einem beliebigen der Ansprüche 1 bis 5, wobei das Wärmeleitpad (60) aus einem verformbaren Material hergestellt ist.

7. Elektrische Ausrüstung (200), die ein Gehäuse und mindestens ein elektrisches Bauteil (101) beinhaltet; wobei das Gehäuse mindestens eine Aufnahme (12) beinhaltet, die durch eine Seitenwand (16) und eine Trägerplatte (15), auf der das mindestens eine elektrische Bauteil (101) montiert ist, definiert wird; wobei die elektrische Ausrüstung (200) **dadurch gekennzeichnet ist, dass** sie Folgendes beinhaltet:
- ein elektrisches Isolationsmodul (5) nach einem beliebigen der Ansprüche 1 bis 6.

8. Elektrische Ausrüstung (200) nach Anspruch 7, wobei sich eine erste Kriechstrecke (71) nacheinander entlang einer oberen Außenoberfläche des Wärmeleitpads (60), die sich zwischen dem elektrischen Bauteil (101) und der Umfangswand (52) befindet, und einer Innenoberfläche der Umfangswand (52), die nicht an dem Wärmeleitpad (60) anliegt, erstreckt.

9. Elektrische Ausrüstung (200) nach Anspruch 7 oder 8, die ein elektrisches Isolationsmodul (5) nach Anspruch 5 beinhaltet, die elektrische Ausrüstung (200), wobei sich eine zweite Kriechstrecke (72) nacheinander entlang einer oberen Außenoberfläche des Wärmeleitpads (60), die sich zwischen dem elektrischen Bauteil (101) und der Umfangswand (52) befindet, einer ersten Kontaktoberfläche zwischen dem Wärmeleitpad (60) und der Umfangswand (52) und einer dritten Kontaktfläche zwischen dem Wärmeleitpad (60) und der Bodenwand (51) bis zu der Trägerplatte (15) erstreckt.

## Claims

1. Electrical insulation module (5) configured to determine at least one line of leakage (71, 72) between an electrical component (101) and a housing receiving said electrical component (101); the electrical insulation module (5) is made of an electrically insulating material and comprises:
- a spacer (50), comprising a bottom wall (51) and a peripheral wall (52), said spacer (50) being configured to define the at least one line of leakage (71, 72) between said electrical component (101) and said housing;
wherein:
• the peripheral wall (52) follows a different direction from that of the bottom wall (51), an internal angle (55) being formed between the bottom wall (51) and the peripheral wall (52); and
• the at least one line of leakage (71, 72) comprises at least one dimension of a surface corresponding to a portion of the bottom wall (51) and/or one dimension of a surface of a portion of the peripheral wall (52);
- a thermal cushion (60) configured to be positioned between said electrical component (101) and said spacer (50), said thermal cushion (60) being configured to discharge at least a part of the heat generated in the operation of the electrical component (101).

2. Electrical insulation module (5) according to Claim 1, wherein said internal angle (55) lies between 80 and 110 degrees.

3. Electrical insulation module (5) according to either one of Claims 1 and 2, wherein said spacer (50) comprises a reception cavity defined by the bottom wall (51) and the peripheral wall (52) and configured to receive at least a portion (101a) of the at least one electrical component (101).

4. Electrical insulation module (5) according to any one of Claims 1 to 3, wherein the peripheral wall (52) comprises a rim (58), the at least one line of leakage (71, 72) further comprising a dimension of a surface of said rim (58).

5. Electrical insulation module (5) according to any one of Claims 1 to 4, wherein the spacer (50) comprises an aperture (56) formed in the bottom wall (51) and configured to allow a contact between the thermal cushion (60) and a wall of the housing so as to discharge at least a part of said generated heat.

6. Electrical insulation module (5) according to any one of Claims 1 to 5, wherein the thermal cushion (60) is made of a deformable material.

7. Electrical equipment (200) comprising a housing and at least one electrical component (101); said housing comprising at least one recess (12) defined by a lateral wall (16) and a support plate (15) on which the at least one electrical component (101) is mounted; the electrical equipment (200) being **characterized in that** it comprises:
- an electrical insulation module (5) according to any one of Claims 1 to 6.

8. Electrical equipment (200) according to Claim 7, wherein a first line of leakage (71) extends successively along a top outer surface of the thermal cushion (60) situated between the electrical component (101) and the peripheral wall (52); and an inner surface of the peripheral wall (52) without the thermal cushion (60).

9. Electrical equipment (200) according to Claim 7 or 8, comprising an electrical insulation module (5) according to Claim 5, said electrical equipment (200) wherein a second line of leakage (72) extends successively along a top outer surface of the thermal cushion (60) situated between the electrical component (101) and the peripheral wall (52); a first contact surface between the thermal cushion (60) and said peripheral wall (52); and a third contact surface between the thermal cushion (60) and said bottom wall (51) to said support plate (15).
